(19) Europäisches Patentamt
European Patent Office
Office européen des brevets

(11) **EP 4 118 359 B1**

(12) **EUROPÄISCHE PATENTSCHRIFT**

(45) Veröffentlichungstag und Bekanntmachung des Hinweises auf die Patenterteilung:
**17.06.2026   Patentblatt 2026/25**

(21) Anmeldenummer: **21710898.4**

(22) Anmeldetag: **04.03.2021**

(51) Internationale Patentklassifikation (IPC):
**F16F 15/08** *(2006.01)*        **H05K 7/14** *(2006.01)*

(52) Gemeinsame Patentklassifikation (CPC):
**H05K 7/1434; F16F 15/08; H05K 7/20445;**
F16F 2222/025

(86) Internationale Anmeldenummer:
**PCT/EP2021/055437**

(87) Internationale Veröffentlichungsnummer:
**WO 2021/180556 (16.09.2021 Gazette 2021/37)**

(54) **VORRICHTUNG ZUM ABFÜHREN VON WÄRME VON EINER STOSSGELAGERTEN ELEKTRISCHEN SCHALTUNG**

DEVICE FOR DISSIPATING HEAT FROM A SHOCK-MOUNTED ELECTRICAL CIRCUIT

DISPOSITIF DE DISSIPATION DE CHALEUR D'UN CIRCUIT ÉLECTRIQUE MONTÉ SUR AMORTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **10.03.2020   DE 102020203025**

(43) Veröffentlichungstag der Anmeldung:
**18.01.2023   Patentblatt 2023/03**

(73) Patentinhaber:
• **TKMS ATLAS ELEKTRONIK GmbH
  28309 Bremen (DE)**
• **thyssenkrupp AG
  45143 Essen (DE)**

(72) Erfinder:
• **THEUERKAUF, Nils
  28865 Lilienthal (DE)**
• **STEGEN, Ole
  22547 Hamburg (DE)**
• **SMITH, Björn
  27419 Groß Meckelsen (DE)**

(74) Vertreter: **thyssenkrupp Intellectual Property GmbH
ThyssenKrupp Allee 1
45143 Essen (DE)**

(56) Entgegenhaltungen:
**EP-A1- 0 622 984        EP-A2- 2 048 928
DE-A1- 10 246 577      US-A- 4 528 615
US-A- 5 400 298**

**Beschreibung**

Die Erfindung bezieht sich auf die Abfuhr von Wärme von einer elektrischen Schaltung (kurz Elektronik), die stoßgelagert in einem Gehäuse angeordnet ist. Elektrische Schaltungen produzieren Wärme. Heutzutage ist die Leistung der elektrischen Komponenten so groß geworden, dass die elektrischen Schaltungen gekühlt werden müssen, d.h. die produzierte Wärme kontrolliert abführen können. In rauen Umgebungen wie z.B. beim Einsatz auf einem Schiff oder einem U-Boot ist die Elektronik jedoch regelmäßig Erschütterungen ausgesetzt. Die Erschütterungen wirken sich auf die Lebensdauer der Elektronik aus. Daher ist es bei solchen Anwendungen notwendig, eine Stoßlagerung der elektrischen Schaltung vorzusehen, d.h. die Erschütterungen zu dämpfen. Beim Einsatz der elektrischen Schaltung für Sonaranwendungen, insbesondere auf einem U-Boot, ist es sogar notwendig, die elektrische Schaltung schockzulagern. Die Schocklagerung erlaubt es der Elektronik auch eine Detonation in der Nähe standzuhalten. Hier können Beschleunigungen bis zu 10.000 g, d.h. der zehntausendfachen Erdbeschleunigung, auftreten. Für die entsprechende Lagerung sind solche Materialien geeignet, die typischerweise keine gute Wärmeleitfähigkeit aufweisen. Ist die Elektronik in einem Gehäuse angeordnet wird die Wärme jedoch typischerweise über das Gehäuse abgeführt. Da die elektrische Schaltung jedoch nur mittels der Lagerung mit dem Gehäuse verbunden ist, kann die Wärme nur über die in dem Gehäuse vorhandene Luft an das Gehäuse abgegeben werden. Dieser Wärmetransport ist jedoch meist nicht ausreichend, um die elektrische Schaltung zuverlässig zu kühlen.

Die EP0622984A1 offenbart eine Vorrichtung zur Stoßlagerung einer elektrischen Baugruppe mit einem Litzband zur Wärmeabführung. Die DE10246577A1 offenbart eine Leiterplatte mit einem Metallgehäuse und einer Blechfeder zur Wärmeableitung.

Die Aufgabe der vorliegenden Erfindung besteht deshalb darin, ein verbessertes Konzept für stoßgelagerte elektrische Schaltungen zu schaffen.

Die Aufgabe wird durch den Gegenstand der unabhängigen Patentansprüche gelöst. Weitere vorteilhafte Ausführungsformen sind der Gegenstand der abhängigen Patentansprüche.

Ausführungsbeispiele zeigen eine Vorrichtung mit einem Gehäuse, in dem eine elektrische Schaltung angeordnet ist. Die elektrische Schaltung ist z.B. eine Platine, die mit Bauteilen bestückt und funktional verdrahtet ist. Die Vorrichtung umfasst eine Stoßlagerung, die ausgebildet ist, eine Stoßwirkung auf die elektrische Schaltung zu dämpfen, so dass eine mechanische Belastung der elektrischen Schaltung gegenüber einer mechanischen Belastung des Gehäuses durch die Stoßwirkung reduziert ist. D.h., die Stoßlagerung ist zwischen der elektrischen Schaltung und dem Gehäuse angeordnet und dämpft die Kräfte, die bei Stößen auf das Gehäuse, auf die elektrische Schaltung wirken. Ein Beispiel für eine Stoßlagerung ist ein O-Ring. Ist eine Komponente, hier die elektrische Schaltung, nur mittels der Stoßlagerung mit dem Gehäuse verbunden, d.h. kann sich die Komponente in alle Richtungen bewegen, wird dies auch als schwimmende Lagerung in dem Gehäuse bezeichnet. Bei der Stoßlagerung handelt es sich explizit nicht um ein Lager, dass eine Bewegung der elektrischen Schaltung ermöglicht, beispielsweise ein Kugellager. In Ausführungsbeispielen weist ein Material der Stoßlagerung ein Elastomer auf.

Die Vorrichtung weist ferner ein Federelement auf, das die elektrische Schaltung und das Gehäuse kontaktiert, wobei das Federelement ausgebildet ist, die Wärme der elektrischen Schaltung an das Gehäuse abzuführen. Vorteilhafterweise ist das Federelement demnach zwischen der elektrischen Schaltung und dem Gehäuse angeordnet. Bei der Kontaktierung handelt es sich um einen mechanischen Kontakt. Insbesondere berührt das Federelement sowohl das Gehäuse als auch die elektrische Schaltung. Das Federelement kann sowohl an dem Gehäuse als auch an der elektrischen Schaltung befestigt, beispielsweise angeklebt, sein. Es ist aber auch möglich, dass das Federelement nur einseitig befestigt ist, entweder an dem Gehäuse oder an der Schaltung. Vorteilhafterweise ist das Federelement in Ruhelage sowohl dehn- als auch stauchbar.

Idee ist es, unabhängig von der Stoßlagerung eine weitere Verbindung zwischen der elektrischen Schaltung und dem Gehäuse vorzusehen, über die die Wärme (insbesondere bevorzugt bzw. überwiegend) von der elektrischen Schaltung an das Gehäuse abgegeben wird. Diese weitere Verbindung darf jedoch die Stoßlagerung nicht beeinträchtigen. Ferner sollte die weitere Verbindung eine bessere Wärmeleitfähigkeit aufweisen, als die Stoßlagerung. Diese Eigenschaften weist ein Federelement auf, das mit der elektrischen Schaltung und dem Gehäuse verbunden ist. Es wird ferner angemerkt, dass im Rahmen dieser Offenbarung der Begriff "elektrisch" auch "elektronisch" umfasst. D.h., die elektrische Schaltung kann auch elektronische Komponenten aufweisen, insbesondere daraus bestehen.

In Ausführungsbeispielen weist die Stoßlagerung einen Wärmeleitkoeffizienten (Einheit: Watt (W) pro Meter (m) und Kelvin (K)) von weniger als $10 \, \frac{\mathrm{W}}{\mathrm{m \cdot K}}$, insbesondere weniger als $2{,}5 \, \frac{\mathrm{W}}{\mathrm{m \cdot K}}$ auf. Demgegenüber kann das Federelement einen Wärmeleitkoeffizienten von mehr als $50 \, \frac{\mathrm{W}}{\mathrm{m \cdot K}}$, insbesondere mehr als $100 \, \frac{\mathrm{W}}{\mathrm{m \cdot K}}$ aufweisen. Dies ermöglicht es, dass die Wärme über das Federelement an das Gehäuse abgegeben wird. Beispielsweise weist das Federelement (überwiegend oder vollständig) ein Metall, beispielsweise Kupfer, auf. So kann das Federelement aus einer Kupferlegierung bestehen oder diese (überwiegend) aufweisen. Kupferlegierungen sind für den Anwendungszweck besonders geeignet, da diese sowohl gut Wärme leiten als auch eine hinreichende Festigkeit aufweisen, um trotz der mechanischen Belastung eine dauerhafte Verbindung zwischen der elektrischen Schaltung und dem Gehäuse zu gewährleisten. Eine mögliche Kupferlegierung ist Messing.

In Ausführungsbeispielen weist das Federelement eine Blattfeder auf, insbesondere ist das Federelement eine Blattfeder. Eine Blattfeder weist verschiedene Eigenschaften auf, die für den Einsatzzweck vorteilhaft sind. Zunächst kann eine Federkraft sehr weich eingestellt werden, so dass das Federelement die Stoßlagerung nicht beeinflusst, der Kontakt zwischen der elektrischen Schaltung und dem Gehäuse aber zuverlässig bestehen bleibt. Ferner kann, z.B. im Unterschied zu einer Spiralfeder, sowohl eine große Kontaktfläche zwischen Gehäuse und Federelement bzw. zwischen elektrischer Schaltung und Federelement realisiert werden, als auch eine großflächige Verbindung zwischen den Kontaktflächen. Gleiches gilt auch für eine Tellerfeder, insbesondere eine Reihenschaltung von Tellerfedern. Bei einer Reihenschaltung werden die Tellerfedern jeweils alternierend, d.h. wechselseitig, miteinander verbunden, so dass eine Gesamtfederkraft der Reihenschaltung geringer ist als eine Federkraft der einzelnen Tellerfeder.

Weiter zeigen Ausführungsbeispiele eine Wasserschallwandleranordnung mit einem Wasserschallwandler sowie der vorgenannten Vorrichtung. Der Wasserschallwandler ist ausgebildet, basierend auf empfangenen Wasserschallwellen ein Wasserschallsignal auszugeben oder basierend auf einem Wasserschallsignal entsprechende Wasserschallwellen abzustrahlen. Der Wasserschallwandler wird auch als Hydrophon bezeichnet. Der Wasserschallwandler wird vorteilhafterweise für Sonaranwendungen eingesetzt. Die elektrische Schaltung ist ausgebildet, das Wasserschallsignal zu verarbeiten. Zum Verarbeiten des Wasserschallsignals kann die elektrische Schaltung eine beliebige Signalverarbeitung aufweisen, beispielsweise einen Analog-Digital-Wandler um die analogen Wasserschallsignale zu digitalisieren oder einen Richtungsbildner um basierend auf einer Vielzahl von Wasserschallsignalen verschiedener Wasserschallwandler eine Richtungsbildung durchzuführen. Das Gehäuse kann von (Meer-) Wasser umgeben sein und somit durch das Wasser eine Kühlung erfahren.

Analog ist ein Verfahren zur Herstellung einer Vorrichtung mit folgenden Merkmalen gezeigt: Anordnen einer elektrischen Schaltung in einem Gehäuse; Anordnen einer Stoßlagerung zwischen der elektrischen Schaltung und dem Gehäuse, wobei die Stoßlagerung ausgebildet ist, eine Stoßwirkung auf die elektrische Schaltung zu dämpfen, so dass eine mechanische Belastung der elektrischen Schaltung gegenüber einer mechanischen Belastung des Gehäuses durch die Stoßwirkung reduziert ist; Anordnen eines Federelements derart, dass das Federelement die elektrische Schaltung und das Gehäuse kontaktiert, wobei das Federelement ausgebildet ist, die Wärme der elektrischen Schaltung an das Gehäuse abzuführen.

Bevorzugte Ausführungsbeispiele der vorliegenden Erfindung werden nachfolgend Bezug nehmend auf die beiliegenden Zeichnungen erläutert. Es zeigen:

Fig. 1: eine schematische Schnittdarstellung einer Vorrichtung in einem ersten nicht erfindungsgemäßen Ausführungsbeispiel in Fig. 1a, einem zweiten nicht erfindungsgemäßen Ausführungsbeispiel in Fig. 1b und einem dritten erfindungsgemäßen Ausführungsbeispiel in Fig. 1c;

Fig. 2: eine schematische leicht perspektivische Draufsicht auf ein Ausführungsbeispiel einer Federanordnung, die in der Vorrichtung verwendet werden kann;

Fig. 3: eine schematische perspektivische Darstellung der Vorrichtung, die als Wasserschallwandleranordnung verwendbar ist.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

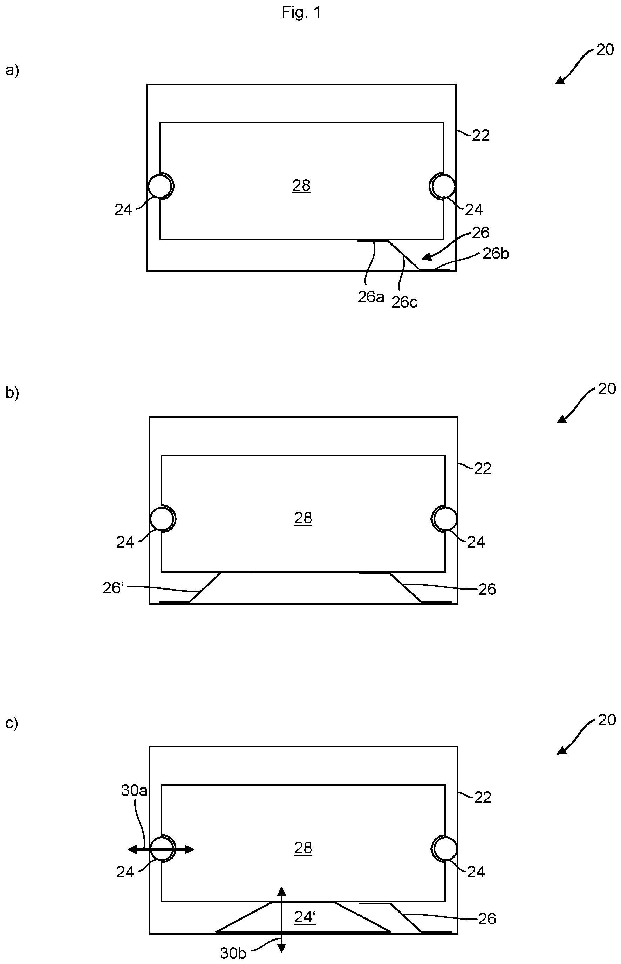

Fig. 1a zeigt eine schematische Schnittdarstellung einer Vorrichtung 20. Die Vorrichtung 20 umfasst ein Gehäuse 22, eine Stoßlagerung 24 und ein Federelement 26. In dem Gehäuse 22 ist eine elektrische Schaltung 28 angeordnet. Die elektrische Schaltung 28 kann beispielsweise eine beliebige Signalverarbeitung durchführen. Die elektrische Schaltung 28 umfasst beispielsweise eine Mehrzahl von Platinen, die in einer (gemeinsamen) Platinenhalterung angeordnet sind. Die Stoßlagerung ist zwischen der elektrischen Platine 28, insbesondere der Platinenhalterung, und dem Gehäuse 22, angeordnet. So kann die Stoßlagerung 24 eine Stoßwirkung auf die elektrische Schaltung 28 dämpfen, so dass eine mechanische Belastung der elektrischen Schaltung 28 gegenüber einer mechanischen Belastung des Gehäuses 22 durch die Stoßwirkung reduziert ist. Dargestellt ist die Stoßlagerung 24 in Form einer umlaufenden Dämpfung. Im Fall eines runden Gehäuses ist die umlaufende Dämpfung z.B. ein umlaufender O-Ring. Die Dämpfung wird auch als Dämpfungselement bezeichnet.

Das Federelement 26 ist in Form einer Blattfeder dargestellt. Das Federelement 26 umfasst eine erste Kontaktfläche 26a zur Kontaktierung der elektrischen Schaltung und eine zweite Kontaktfläche 26b zur Kontaktierung des Gehäuses 22. Zwischen der ersten und der zweiten Kontaktfläche 26a, 26b ist eine Verbindungsfläche 26c angeordnet. Somit kann ein Wärmetransport von der elektrischen Schaltung 28 über die erste Kontaktfläche 26a, die Verbindungsfläche 26c, die zweite Kontaktfläche 26b zu dem Gehäuse 22 erfolgen.

In anderen Worten kontaktiert das Federelement 26 die elektrische Schaltung 28 und das Gehäuse 22, so dass Wärme von der elektrischen Schaltung 28 an das Gehäuse 22 abgegeben wird. Hierzu ist das Federelement 26 zwischen der elektrischen Schaltung 28 und dem Gehäuse 22 angeordnet. Eine Federkraft des Federelements 26 ist so gewählt, dass das Federelement 26 die elektrische Schaltung sicher kontaktiert, aber die Dämpfungswirkung der Stoßlagerung 24 nicht beeinträchtigt.

Fig. 1b zeigt ein Ausführungsbeispiel der Vorrichtung aus Fig. 1a. Hier ist ein zweites Federelement 26' gezeigt. Das zweite Federelement 26' kann äquivalent zu dem Federelement 26' ausgestaltet sein. In einer Anordnung mit zwei Federelementen wird die effektive Fläche zur Abfuhr der Wärme erhöht. Generell können die Federelemente 26 in ihrer Anzahl und Form so gewählt werden, dass diese optimal an die elektrische Schaltung angepasst sind.

Fig. 1c zeigt ein weiteres Ausführungsbeispiel der Vorrichtung aus Fig. 1a, wobei auch die Ausführungsbeispiele aus Fig. 1b und 1c kombiniert werden können.

In Fig. 1c umfasst die Stoßlagerung neben der umlaufenden Dämpfung 24 eine Auflagedämpfung 24'. Die Auflagedämpfung wird auch als Dämpfungsmatte bezeichnet. Die umlaufende Dämpfung 24 kann dann Stöße dämpfen, die lateral auf das Gehäuse 22 wirken (d.h. Stoßrichtung entsprechend des Pfeils 30a). Die Auflagedämpfung 24' kann dann Stöße dämpfen, die in Dickenrichtung auf das Gehäuse 22 wirken (d.h. Stoßrichtung entsprechend des Pfeils 30b). Diese Anordnung ist vorteilhaft, wenn die umlaufende Dämpfung 24 nicht ausreicht, Stöße in Dickenrichtung 30b zu dämpfen, so dass die Gefahr eines Defekts der elektrischen Schaltung 28 durch die Stöße in Dickenrichtung 30b besteht. Die Auflagedämpfung 24' wird auch als Auflagedämpfungselement bezeichnet. Die umlaufende Dämpfung 24 und die Auflagedämpfung 24' können derart eingestellt sein, dass die elektrische Schaltung optimal gegen Stöße gedämpft ist.

Insbesondere bei einem Einsatz in einer Sonaranwendung kann die Stoßlagerung ausgebildet sein, einen Schock auszuhalten. Die Stoßlagerung wird dann auch als Schocklagerung bezeichnet.

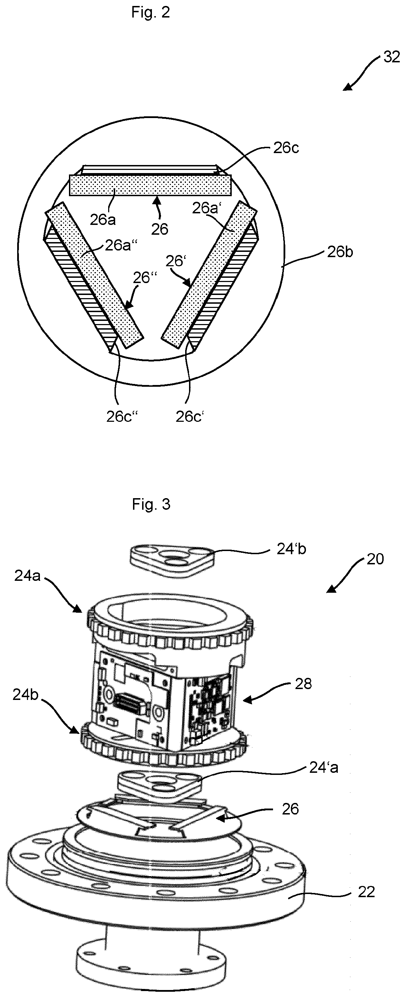

Fig. 2 zeigt eine schematische perspektivische Draufsicht auf eine exemplarische Federanordnung 32 mit drei Federelementen 26, 26', 26". Das erste Federelement 26' weist die erste Kontaktfläche 26a und die erste Verbindungsfläche 26c auf. Das zweite Federelement 26' weist eine erste Kontaktfläche 26a' und eine erste Verbindungsfläche 26c' auf. Das dritte Federelement 26" weist eine erste Kontaktfläche 26a" und eine erste Verbindungsfläche 26c" auf. Alle drei Federelemente 26, 26', 26" weisen die zweite Kontaktfläche 26b als gemeinsame Kontaktfläche auf. Die Verbindungsflächen 26c, 26c', 26c" verbinden die ersten Kontaktflächen 26a, 26a', 26a" mit der gemeinsamen zweiten Kontaktfläche 26b. Die zweite Kotaktfläche 26b liegt in einer ersten Ebene. Die ersten Kontaktflächen 26a, 26a', 26a" liegen in einer zweiten Ebene. Die erste Ebene liegt tiefer in der Bildebene als die zweite Ebene. Die Verbindungsflächen 26c, 26c', 26c" sind somit schräg angeordnet, um die erste Ebene mit der zweiten Ebene zu verbinden. Die Federanordnung 32 ist eine Möglichkeit, um das Federelement bzw. eine Mehrzahl von Federelementen in der Vorrichtung anzuordnen.

Fig. 3 zeigt eine Explosionszeichnung der Vorrichtung in einer schematischen perspektivischen Darstellung, die mit (nicht gezeigten) Wasserschallwandlern als Wasserschallwandleranordnung verwendet wird. Die Vorrichtung 20 weist zwei umlaufende Dämpfungen 24a, 24b (erste und zweite Dämpfung) auf. Die Verwendung von zwei umlaufenden Dämpfungen ist vorteilhaft, um ein Verkippen der elektrischen Schaltung mit den umlaufenden Dämpfungen gegen das Gehäuse zu verhindern. Wenn die elektrische Schaltung verkippt kann die Dämpfungswirkung der Dämpfungen und/oder die Wärmeabfuhr mittels des Federelements verringert werden. Die umlaufenden Dämpfungen 24a, 24b weisen jeweils Einkerbungen auf.

Mittels der Einkerbungen ist eine Dämpfungswirkung der Dämpfungen eingestellt. Das heißt, mittels der Einkerbungen wird eingestellt, wie hart bzw. weich die Dämpfungswirkung der Dämpfung ist. Die Dämpfungswirkung der umlaufenden Dämpfungen wirkt in Richtung der vorgesehenen Nutzungsorientierung, in diesem Fall in der Horizontalen.

Die elektrische Schaltung 28 ist in Form einer Platine dargestellt. Die elektrische Schaltung 28 ist jeweils zwischen den umlaufenden Dämpfungen 24a, 24b und den Auflagedämpfungen 24'a, 24'b angeordnet.

Ferner weist die Vorrichtung 20 zwei Auflagedämpfungen 24'a, 24'b (erste und zweite Auflagedämpfung) auf. Die Dämpfungswirkung der umlaufenden Dämpfungen wirkt im Wesentlichen senkrecht zu der vorgesehenen Nutzungsorientierung, in diesem Fall in der Horizontalen. Die Federelemente 26 sind so angeordnet, dass die erste Auflagedämpfung 24'a sich in eine Öffnung, die die Federelemente 26 bilden, einfügt. Die Federelemente 26 sind vorteilhafterweise mit dem Gehäuse 22 verbunden. Das Gehäuse 22 ist jedoch zur Vereinfachung der Darstellung nur in Teilen dargestellt.

Die offenbarten (Wasser-) Schallwandler sind für den Einsatz unter Wasser, insbesondere im Meer, ausgelegt. Die Schallwandler sind ausgebildet, Wasserschall in ein dem Schalldruck entsprechendes elektrisches Signal (z.B. Spannung oder Strom), das Wasserschallsignal, umzuwandeln. Überdies sind die Schallwandler ausgebildet, eine anliegende elektrische Spannung in Wasserschall umzuwandeln. Die Schallwandler können demnach als Wasserschallempfänger und/oder als Wasserschallsender verwendet werden. Die Schallwandler sind nicht für medizinische Anwendungen geeignet.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Bezugszeichenliste:

20 Vorrichtung
22 Gehäuse
24 Stoßlagerung
26 Federelement
28 elektrische Schaltung
30 Pfeil, der die Stoßrichtung anzeigt
32 Federanordnung

**Patentansprüche**

1. Vorrichtung (20) mit folgenden Merkmalen:

einem Gehäuse (22), in dem eine elektrische Schaltung (28) angeordnet ist;
einer Stoßlagerung (24), die ausgebildet ist, eine Stoßwirkung auf die elektrische Schaltung zu dämpfen, so dass eine mechanische Belastung der elektrischen Schaltung gegenüber einer mechanischen Belastung des Gehäuses durch die Stoßwirkung reduziert ist, wobei die Stoßlagerung eine umlaufende Dämpfung (24) und eine Auflagedämpfung (24') umfasst;
einem Federelement (26) in Form einer Blattfeder, wobei eine erste Kontaktfläche (26a) der Blattfeder die elektrische Schaltung und eine zweite Kontaktfläche (26b) der Blattfeder das Gehäuse (22) kontaktiert, wobei zwischen der ersten Kontaktfläche (26a) und der zweiten Kontaktfläche (26b) eine Verbindungsfläche (26c) angeordnet ist, um die Wärme der elektrischen Schaltung über die erste Kontaktfläche (26a), die Verbindungsfläche (26c) und die zweite Kontaktfläche (26b) an das Gehäuse (22) abzuführen.

2. Vorrichtung (20) gemäß Anspruch 1, wobei ein Material der Stoßlagerung (24) ein Elastomer aufweist.

3. Vorrichtung (20) gemäß einem der vorherigen Ansprüche, wobei die Stoßlagerung (24) einen Wärmeleitkoeffizienten von weniger als $10\,\frac{W}{m\cdot K}$, insbesondere weniger als $2{,}5\,\frac{W}{m\cdot K}$ aufweist.

4. Vorrichtung (20) gemäß einem der vorherigen Ansprüche, wobei das Federelement (26) eine Tellerfeder, insbesondere eine Reihenschaltung von Tellerfedern, umfasst.

5. Vorrichtung (20) gemäß einem der vorherigen Ansprüche, wobei das Federelement (26) einen Wärmeleitkoeffizienten von mehr als $50\,\frac{W}{m\cdot K}$, insbesondere mehr als $100\,\frac{W}{m\cdot K}$ aufweist.

6. Vorrichtung (20) gemäß einem der vorherigen Ansprüche, wobei ein Material des Federelements ein Metall aufweist.

7. Vorrichtung (20) gemäß einem der vorherigen Ansprüche, wobei die Stoßlagerung (24) die elektrische Schaltung schwimmend lagert.

8. Wasserschallwandleranordnung mit folgenden Merkmalen:

einem Wasserschallwandler, der ausgebildet ist, basierend auf empfangenen Wasserschallwellen ein Wasserschallsignal auszugeben oder basierend auf einem Wasserschallsignal entsprechende Wasserschallwellen abzustrahlen;
der Vorrichtung (20) gemäß einem der Ansprüche 1 bis 7, wobei die elektrische Schaltung ausgebildet ist, das Wasserschallsignal zu verarbeiten.

9. Verfahren zur Herstellung einer Vorrichtung (20) mit folgenden Schritten:

- Anordnen einer elektrischen Schaltung (28) in einem Gehäuse;
- Anordnen einer Stoßlagerung (24) zwischen der elektrischen Schaltung (28) und dem Gehäuse (22), wobei die Stoßlagerung (24) ausgebildet ist, eine Stoßwirkung auf die elektrische Schaltung zu dämpfen, so dass eine mechanische Belastung der elektrischen Schaltung gegenüber einer mechanischen Belastung des Gehäuses durch die Stoßwirkung reduziert ist, wobei die Stoßlagerung eine umlaufende Dämpfung (24) und eine Auflagedämpfung (24') umfasst;
- Anordnen einer Blattfeder als Federelements derart, dass eine erste Kontaktfläche (26a) der Blattfeder die elektrische Schaltung und eine zweite Kontaktfläche (26b) der Blattfeder das Gehäuse (22) kontaktiert, wobei zwischen der ersten Kontaktfläche (26a) und der zweiten Kontaktfläche (26b) eine Verbindungsfläche (26c) angeordnet ist, um die Wärme der elektrischen Schaltung über die erste Kontaktfläche (26a), die Verbindungsfläche (26c) und die zweite Kontaktfläche (26b) an das Gehäuse (22) abzuführen.

**Claims**

1. Device (20) having the following features:

   a housing (22), in which an electrical circuit (28) is arranged;
   an impact mounting (24), which is configured to damp an impactct on the electrical circuit so that a mechanical load on the electrical circuit relative to a mechanical load on the housing due to the impact effect is reduced, wherein the impact mounting comprises a circumferential damping (24) and a support damping (24');
   a spring element (26) in the form of a leaf spring, wherein a first contact surface (26a) of the leaf spring contacts the electrical circuit and a second contact surface (26b) of the leaf spring contacts the housing (22), wherein a connecting surface (26c) is arranged between the first contact surface (26a) and the second contact surface (26b), in order to dissipate the heat of the electrical circuit via the first contact surface (26a), the connecting surface (26c) and the second contact surface (26b) to the housing (22).

2. Device (20) according to claim 1, wherein a material of the impact mounting (24) comprises an elastomer.

3. Device (20) according to one of the preceding claims, wherein the impact mounting (24) has a thermal conductivity coefficient of less than $10 \frac{W}{m \cdot K}$, in particular less than $2.5 \frac{W}{m \cdot K}$.

4. Device (20) according to one of the preceding claims, wherein the spring element (26) comprises a disc spring, in particular a series connection of disc springs.

5. Device (20) according to one of the preceding claims, wherein the spring element (26) has a thermal conductivity coefficient of more than $50 \frac{W}{m \cdot K}$, in particular more than $100 \frac{W}{m \cdot K}$.

6. Device (20) according to one of the preceding claims, wherein a material of the spring element comprises a metal.

7. Device (20) according to one of the preceding claims, wherein the impact mounting (24) floatingly mounts the electrical circuit.

8. Waterborne sound transducer arrangement having the following features:

   a waterborne sound transducer, which is configured, based on received waterborne sound waves, to output a waterborne sound signal or, based on a waterborne sound signal, to emit corresponding waterborne sound waves;
   the device (20) according to one of claims 1 to 7, wherein the electrical circuit is configured to process the waterborne sound signal.

9. Method for producing a device (20), having the following steps:

   • arranging an electrical circuit (28) in a housing;
   • arranging an impact mounting (24) between the electrical circuit (28) and the housing (22), wherein the impact mounting (24) is configured to damp an impact effect on the electrical circuit so that a mechanical load on the electrical circuit relative to a mechanical load on the housing due to the impact effect is reduced, wherein the impact mounting comprises a circumferential damping (24) and a support damping (24');
   • arranging a leaf spring as a spring element such that a first contact surface (26a) of the leaf spring contacts the electrical circuit and a second contact surface (26b) of the leaf spring contacts the housing (22), wherein a connecting surface (26c) is arranged between the first contact surface (26a) and the second contact surface (26b), in order to dissipate the heat of the electrical circuit via the first contact surface (26a), the connecting surface (26c) and the second contact surface (26b) to the housing (22).

**Revendications**

1. Dispositif (20) présentant les caractéristiques suivantes :

   un boîtier (22), dans lequel un circuit électrique (28) est disposé ;
   un palier antichoc (24), qui est réalisé pour amortir un effet de choc sur le circuit électrique de telle sorte qu'une sollicitation mécanique du circuit électrique soit réduite par rapport à une sollicitation mécanique du boîtier due à l'effet de choc, le palier antichoc comprenant un amortissement périphérique (24) et un amortissement d'appui (24') ;
   un élément ressort (26) sous la forme d'un ressort à lame, une première surface de contact (26a) du ressort à lame contactant le circuit électrique et une deuxième surface de contact (26b) du ressort à lame contactant le boîtier (22), une surface de liaison (26c) étant disposée entre la première surface de contact (26a) et la deuxième surface de contact (26b), afin d'évacuer la chaleur du circuit électrique vers le boîtier (22) par l'intermédiaire de la première surface de contact (26a), de la surface de liaison (26c) et de la deuxième surface de contact (26b).

2. Dispositif (20) selon la revendication 1, dans lequel un matériau du palier antichoc (24) présente un élastomère.

3. Dispositif (20) selon l'une des revendications précédentes, dans lequel le palier antichoc (24) présente un coefficient de conductivité thermique inférieur à $10\,\frac{W}{m\cdot K}$, en particulier inférieur à $2{,}5\,\frac{W}{m\cdot K}$.

4. Dispositif (20) selon l'une des revendications précédentes, dans lequel l'élément ressort (26) comprend une rondelle ressort, en particulier un montage en série de rondelles ressorts.

5. Dispositif (20) selon l'une des revendications précédentes, dans lequel l'élément ressort (26) présente un coefficient de conductivité thermique supérieur à $50\,\frac{W}{m\cdot K}$, en particulier supérieur à $100\,\frac{W}{m\cdot K}$.

6. Dispositif (20) selon l'une des revendications précédentes, dans lequel un matériau de l'élément ressort présente un métal.

7. Dispositif (20) selon l'une des revendications précédentes, dans lequel le palier antichoc (24) supporte le circuit électrique de manière flottante.

8. Agencement de transducteur acoustique sous-marin présentant les caractéristiques suivantes :

   un transducteur acoustique sous-marin, qui est réalisé pour émettre, sur la base d'ondes acoustiques sous-marines reçues, un signal acoustique sous-marin ou pour rayonner, sur la base d'un signal acoustique sous-marin, des ondes acoustiques sous-marines correspondantes ;
   le dispositif (20) selon l'une des revendications 1 à 7, le circuit électrique étant réalisé pour traiter le signal acoustique sous-marin.

9. Procédé de fabrication d'un dispositif (20), présentant les étapes suivantes :

   • disposition d'un circuit électrique (28) dans un boîtier ;
   • disposition d'un palier antichoc (24) entre le circuit électrique (28) et le boîtier (22), le palier antichoc (24) étant réalisé pour amortir un effet de choc sur le circuit électrique de telle sorte qu'une sollicitation mécanique du circuit électrique soit réduite par rapport à une sollicitation mécanique du boîtier due à l'effet de choc, le palier antichoc comprenant un amortissement périphérique (24) et un amortissement d'appui (24') ;
   • disposition d'un ressort à lame en tant qu'élément ressort de telle sorte qu'une première surface de contact (26a) du ressort à lame contacte le circuit électrique et qu'une deuxième surface de contact (26b) du ressort à lame contacte le boîtier (22), une surface de liaison (26c) étant disposée entre la première surface de contact (26a) et la deuxième surface de contact (26b), afin d'évacuer la chaleur du circuit électrique vers le boîtier (22) par l'intermédiaire de la première surface de contact (26a), de la surface de liaison (26c) et de la deuxième surface de contact (26b).

Fig. 1

a)

b)

c)

Fig. 2

Fig. 3

**IN DER BESCHREIBUNG AUFGEFÜHRTE DOKUMENTE**

**In der Beschreibung aufgeführte Patentdokumente**

- EP 0622984 A1

- DE 10246577 A1